# EUROPEAN PATENT SPECIFICATION

(11) **EP 3 196 338 B1**
(45) Date of publication and mention of the grant of the patent: **18.12.2019**
(21) Application number: 15849159.7
(22) Date of filing: 28.08.2015
(51) Int. Cl.: C23C 18/16

(54) **PLASTIC PRODUCT AND METHOD FOR SELECTIVELY METALLIZING SURFACE OF PLASTIC BASE MATERIAL**
KUNSTSTOFFGEGENSTAND UND VERFAHREN ZUR SELEKTIVEN METALLISIERUNG DER OBERFLÄCHE EINES MATERIALS AUF KUNSTSTOFFBASIS
PRODUIT EN PLASTIQUE ET PROCÉDÉ DE MÉTALLISATION SÉLECTIVE D'UNE SURFACE D'UN MATÉRIAU DE BASE EN PLASTIQUE

(30) Priority: 10.10.2014 CN 201410529847
(43) Date of publication of application: 26.07.2017
(73) Proprietor: BYD Company Limited, Shenzhen, Guangdong 518118 (CN)
(72) Inventor: ZHOU, Wei, Shenzhen Guangdong 518118 (CN); MIAO, Weifeng, Shenzhen Guangdong 518118 (CN); MAO, Bifeng, Shenzhen Guangdong 518118 (CN); ZHOU, Fangxiang, Shenzhen Guangdong 518118 (CN)
(74) Representative: Hoffmann Eitle
(86) International application number: PCT/CN2015/088395
(87) International publication number: WO 2016/054955

(56) References cited:
- CN-A- 101 240 418
- CN-A- 101 550 546
- CN-A- 101 550 546
- CN-A- 103 757 615
- TW-A- 201 331 428
- US-A- 5 599 592
- US-A1- 2004 157 975
- US-A1- 2009 104 557
- US-A1- 2014 076 616

## Description

### FIELD

Embodiments of the disclosure generally relate to a metallized plastic article, and a method for selectively metallizing a surface.

### BACKGROUND

Providing a metal plating layer on a selected area of a surface of an insulating substrate, such as a plastic article, in order to form a passage for transmitting electro-magnetic signals is widely applied in the field of automobile, computer, communications, etc. The metal plating layer can be formed on the surface of the insulating substrate, such as a plastic article, in various ways.

Currently, when forming a metal plating layer on a selected area of a surface of an insulating substrate, such as a plastic substrate, usually, a metal oxide is present in the insulating substrate, such as a plastic substrate, and then the insulating substrate is selectively metallized via chemical plating after being irradiated by laser. The metal oxide usually includes antimony doped tin oxide. However, the antimony doped tin oxide has a poor light absorption performance and chemical plating activity.

US2014076616 A1 discloses a method for metallizing a blended thermoplastic composition wherein an LDS additive is provided as antimony-doped tin oxide.

### SUMMARY

In viewing thereof, the present disclosure is directed to solving at least one problem existing in the art, for example, the conventional antimony doped tin oxide has a poor light absorption performance and chemical plating activity, thus to provide a plastic article with high absorption performance and chemical plating activity. The present disclosure is also directed to a method for selectively metallizing a surface of an article.

With intensive research, the inventors have found that the tin oxide doped with at least one selected from a group consisting of cerium and lanthanum may have a light absorption performance much higher than antimony doped tin oxide. Even with a relatively low dosage, or irradiating by a laser with a low power, the surface of the insulating substrate could also be removed to expose the tin oxide doped with at least one selected from a group consisting of cerium and lanthanum. The exposed tin oxide doped with at least one selected from a group consisting of cerium and lanthanum has an extremely high chemical plating activity.

In some embodiments, the present disclosure provides a metallized plastic article according to claim 1. According to embodiments of the present disclosure, the metallized plastic article includes a plastic substrate and a metal plating layer formed on a surface of the plastic substrate. At least a surface layer of the plastic substrate covered by the metal plating layer is formed by a plastic composition. The plastic composition includes a base resin and a doped tin oxide. A doping element of the doped tin oxide is at least one selected from a group consisting of cerium and lanthanum.

The present disclosure further provides a method for selectively metallizing a surface of a plastic substrate. The method includes: removing at least a part of the plastic substrate by irradiating a surface of the plastic substrate with an energy source; and forming at least one metal plating layer on the surface of the plastic substrate by chemical plating. At least a surface layer of the plastic substrate covered by the metal plating layer is formed by a plastic composition. The plastic composition includes a base resin and a doped tin oxide. A doping element of the doped tin oxide is at least one selected from a group consisting of cerium and lanthanum.

The present disclosure further provides a metallized plastic article obtained by the method as mentioned above.

According to the present disclosure, when the doped tin oxide of the present disclosure is added into the base resin, the plastic article obtained may have a better energy absorption capability. Even with a relatively low dosage, the surface of the insulating substrate could also be removed to expose the doped tin oxide, and the exposed doped tin oxide has an extremely high chemical plating activity. Thus a metal plating layer could be easily plated on the surface of the plastic article.

Additional aspects and advantages of the embodiments of the present disclosure will be described in detail in part in the following detailed description.

### DETAILED DESCRIPTION

Reference will be made in detail to embodiments of the present disclosure. The embodiments described herein with reference to the accompanying drawings are explanatory and illustrative, which are used to assist in generally understanding the present disclosure. The embodiments shall not be construed to limit the present disclosure.

Embodiments of a first aspect of the present disclosure provides a metallized plastic article, which includes a plastic substrate and a metal plating layer formed on a surface of the plastic substrate. At least a surface layer of the plastic substrate covered by the metal plating layer is formed by a plastic composition, which includes a base resin and a doped tin oxide. A doping element of the doped tin oxide is at least one selected from a group consisting of cerium and lanthanum. In other words, the metallized plastic article includes a plastic substrate and a metal plating layer formed on a surface of the plastic substrate. The surface of the plastic substrate, on which the metal plating layer is formed, is formed by a plastic composition. The plastic composition includes a base resin and at least one kind of doped tin oxide or a filler coated by the doped tin oxide. A doping element of the doped tin oxide is at least one selected from a group consisting of cerium and lanthanum.

In some embodiments, based on total molar quantity of the tin element and the doping element of the doped tin oxide, the tin element has a content of 90 mol% to 99.9 mol%, preferably 92 mol% to 99 mol%, and the doping element has a content of 0.1 mol% to 10 mol%, preferably 1 mol% to 8 mol%. In other words, based on total molar quantity of the tin element and the doping element of the doped tin oxide, the doping element has a content of 0.1 mol% to 10 mol%, preferably 1 mol% to 8 mol%, and the tin element has a content of 90 mol% to 99.9 mol%, preferably 92 mol% to 99 mol%. It should be noted that when the doped tin oxide includes multiple kinds of doping elements selected from a group consisting of cerium and lanthanum, there is no special limit to the ratio between the multiple kinds of doping elements, as long as the total amount of the multiple kinds of doping elements meets the requirements as mentioned above.

In some embodiments, the doped tin oxide includes cerium doped tin oxide or lanthanum doped tin oxide. In some embodiments, a volume average particle size of the doped tin oxide may be appropriately selected according to practical requirements. For example, in some embodiments, the doped tin oxide has a volume average particle size of 50 nm to 10 µm, preferably 300 nm to 5 µm, more preferably 1 µm to 3.5 µm. The average particle size may be measured by a Laser Particle Analyzer.

In some embodiments, the plastic composition further includes a filler coated by the doped tin oxide.

According to embodiments of the present embodiments, there is no special limit to a particle size of the filler coated by the doped tin oxide. The particle size of the filler coated by the doped tin oxide may be appropriately selected according to practical requirements. In some embodiments, the filler has a volume average particle size of 50 nm to 10 µm, preferably 300 nm to 5 µm, more preferably 1 µm to 3.5 µm. In other words, a volume average particle size of the filler coated by the doped tin oxide is 50 nm to 10 µm, preferably 300 nm to 5 µm, more preferably 1 µm to 3.5 µm. The average particle size may be measured by a Laser Particle Analyzer.

In some embodiments, the filler (namely the filler coated by the doped tin oxide) may be any filler commonly used in the art. In some embodiments, the filler may be at least one selected from mica and silicon dioxide. That is, the filler includes mica and/or silicon dioxide.

According to embodiments of the present disclosure, the doped tin oxide has a light color.

According to embodiments of the present disclosure, when the tin oxide is doped with cerium or lanthanum element, the cerium or lanthanum element is present in the doped tin oxide in an oxide state. The tin oxide means a compound formed by tin element and oxygen element. In one aspect, tin oxide refers to a tin dioxide. The cerium oxide means a compound formed by cerium element and oxygen element. In one aspect, cerium oxide refers to a cerium dioxide. The lanthanum oxide means a compound formed by lanthanum element and oxygen element. In one aspect, lanthanum oxide refers to a lanthanum trioxide.

According to embodiments of the present disclosure, the doped tin oxide may be prepared via a commonly used method in the art. For example, the doped tin oxide may be prepared via liquid sintering method and solid state sintering method.

According to embodiments of the present disclosure, the liquid sintering method could be method A, method B, or method C as stated below.

Method A includes steps of: dissolving a compound containing tin element, a compound containing doping element, citric acid, and ethylene glycol in a solvent to form a mixture; esterifying the mixture; and then sintering the obtained product.

According to embodiments of the present disclosure, the method A could be used for manufacturing tin oxide doped by at least one of cerium element and lanthanum element.

Method B includes steps of: dissolving a compound containing tin element, citric acid, and ethylene glycol in a solvent to form a mixture; esterifying the mixture; and add hydrogen fluoride into the obtained product and then sintering.

Method B could be used for manufacturing tin oxide doped by fluorine element.

Method C includes steps of: dissolving a compound containing tin element, compound containing doping element (not include fluorine element), citric acid, and ethylene glycol in a solvent to form a mixture; esterifying the mixture; and add hydrogen fluoride into the obtained product and then sintering.

Method C could be used for manufacturing tin oxide doped by fluorine element and the other doping element of the present disclosure.

According to the liquid sintering method of the present disclosure, the compound containing tin element could be stannic citrate and/or stannic acetate.

According to the liquid sintering method of the present disclosure, the compound containing doping element could be at least one of lanthanum nitrate hexahydrate, cerium nitrate hexahydrate, tantalum pentachloride, and hydrofluoric acid.

According to the liquid sintering method of the present disclosure, the dosage of the compound containing tin element and the compound containing doping element could be regulated according to the content of the tin element and the doping element in the expected doped tin oxide. Specifically, based on total molar quantity of tin element and the doping element of the compound containing tin element and the compound containing doping element, the tin element has a content of 90 mol% to 99.9 mol%, preferably 92 mol% to 99 mol%, and the doping element has a content of 0.1 mol% to 10 mol%, preferably 1 mol% to 8 mol%.

According to the liquid sintering method of the present disclosure, the dosage of the citric acid and the ethylene glycol could be regulated according to the compound containing tin element, based on 1 molar of the compound containing tin element, the dosage of the citric acid and the ethylene glycol could be 4 molar to 6 molar and 10 molar to 12 molar, respectively.

According to the liquid sintering method of the present disclosure, the solvent could be at least one of nitric acid, hydrochloric acid, and phosphoric acid. In some embodiments, the solvent includes nitric acid. It should be noted that there are no particular limitations for the dosage of the solvent, as long as the raw materials could be dissolved sufficiently.

According to the liquid sintering method of the present disclosure, there are no particular limitations for conditions of esterifying. For example, in some embodiments, the temperature of esterifying could be 160 Celsius degrees to 190 Celsius degrees, and the esterifying time could be 30 minutes to 240 minutes, preferably, 60 minutes to 180 minutes.

According to the liquid sintering method of the present disclosure, the temperature of sintering could be 450 Celsius degrees to 1000 Celsius degrees, preferably 500 Celsius degrees to 900 Celsius degrees, and the sintering time could be 6 hours to 24 hours, preferably 10 hours to 20 hours.

According to embodiments of the present disclosure, the solid state sintering method includes step of roasting a powder mixture. The powder mixture contains tin oxide and compound containing doping element. The compound containing doping element includes oxide containing the doping element.

When the doping element includes cerium element, the oxide containing the doping element includes oxide containing cerium, for example, ceric oxide. When the doping element includes lanthanum element, the oxide containing the doping element includes oxide containing lanthanum, for example, lanthanum oxide.

In some embodiments of the present disclosure, based on total molar quantity of tin element and the doping element of the doped tin oxide, the tin element has a content of 90 mol% to 99.9 mol%, preferably 92 mol% to 99 mol%; and the doping element has a content of 0.1 mol% to 10 mol%, preferably 1 mol% to 8 mol%. It should be noted that there are no particular limitations for the proportion of the doping elements when the doping element includes multiple elements (cerium and lanthanum), as long as the total molar quantity of the doping elements meets the requirements stated above.

According to the solid state sintering method of the present disclosure, there are no particular limitations for the method of manufacturing the powder mixture. Any common method could be used. For example, the tin oxide and the compound containing doping element could be grinded to obtain the powder mixture. The grinding method could be dry-grinding or wet-grinding, or half-dry grinding. It should be noted that a dispersing agent of the wet-grinding could be any commonly used dispersing agent in grinding field. Specifically, the dispersing agent could be water and/or C1 - C5 alcohol (for example, ethyl alcohol). It should be noted that the dosage of the dispersing agent could be regulated according to common practice, and there is no particular limitation. When the wet-grinding or half-dry grinding method is carried out, the mixture obtained could be dried to obtain the powder mixture. The drying could be any common drying method. Specifically, a temperature of the drying could be 40 Celsius degrees to 120 Celsius degrees. The drying could be carried out under an oxygen atmosphere or a non-active atmosphere. In embodiments of the present disclosure, the oxygen atmosphere could be air atmosphere or an atmosphere obtained by mixing oxygen and non-active gas. It should be noted that the non-active atmosphere refers to gases that could not react with the constituent of the powder mixture or generated metal compound, for example gases of group 0 in periodic table of the elements or nitrogen. The gases of group 0 in periodic table of the elements could be argon.

According to the solid state sintering method of the present disclosure, there are no particular limitations for the particle size of powder mixture, and it could be any common selection. Generally, a volume average diameter of the powder mixture could be 50 nanometers to 10 microns.

According to the solid state sintering method of the present disclosure, a temperature of roasting could be 800 Celsius degrees to 1100 Celsius degrees, preferably 850 Celsius degrees to 1050 Celsius degrees. The conditions of roasting could be selected according to the temperature of roasting. Generally, the roasting could be carried out for 1 hour to 24 hours, preferably 12 hours to 20 hours. The roasting could be carried out in an atmosphere containing oxygen, and the roasting could also be carried out in a non-active atmosphere.

According to the solid state sintering method of the present disclosure, the obtained product could be further grinded, such that a particle size of the product could meet requirements of specific applications. Generally, the conditions of the grinding could be selected such that a volume average diameter of the product after grinding is 50 nanometers to 10 microns, preferably 300 nanometers to 5 microns, more preferably 1 micron to 3.5 microns. The grinding method could be dry-grinding or wet-grinding, or half-dry grinding. It should be noted that a dispersing agent of the wet-grinding could be any commonly used dispersing agent in grinding field. Specifically, the dispersing agent could be water and/or C1 - C5 alcohol (for example, ethyl alcohol). It should be noted that the dosage of the dispersing agent could be regulated according to common practice, and there is no particular limitation.

In embodiments of the present disclosure, there is no particular limitation for the manufacturing method of the filler coated by the doped tin oxide, and it could be any commonly used coating method in the art. For example, the filler could be added in the above-mentioned method A, and the method A could be proceeded according to its conditions. That is, dissolving the compound containing tin element, the compound containing doping element, the filler, citric acid, and ethylene glycol in a solvent to form a mixture; esterifying the mixture, and then sintering the obtained product. It should be noted that the dosage of the filler could be any common dosage. Preferably, based on 1 molar of the compound containing tin element, the filler has a content of 0.01 molar to 0.1 molar, preferably 0.02 molar to 0.05 molar, more preferably 0.02 molar to 0.03 molar.

In some embodiments, in the plastic composition, based on 100 weight parts of the base resin, the doped tin oxide has a content of 1 weight part to 20 weight parts. Preferably, based on 100 weight parts of the base resin, the doped tin oxide has a content of 3 weight parts to 10 weight parts.

In some embodiments, in the plastic composition, based on 100 weight parts of the base resin, the filler has a content of 1 weight part to 20 weight parts. Preferably, based on 100 weight parts of the base resin, the filler has a content of 3 weight parts to 10 weight parts. In other words, in the plastic composition, with respect to 100 weight parts of the base resin, the filler has a content of 1 weight part to 20 weight parts. Preferably, with respect to 100 weight parts of the base resin, the filler has a content of 3 weight parts to 10 weight parts.

According to the present disclosure, the base resin may be a thermoplastic resin or a thermosetting resin. By way of example and without limits, in some embodiments the base resin may be at least one selected from a group consisting of polyolefin (such as polystyrene, polypropylene, poly(methyl methacrylate) and poly(acrylonitrile-butadiene-styrene)), polycarbonate, polyester (such as poly(cyclohexylene dimethylene terephthalate), poly(diallyl isophthalate), poly(diallyl terephthalate), poly(butylene naphthalate), poly(ethylene terephthalate) and poly(butylene terephthalate)), polyamide (such as poly(hexamethylene adipamide), poly(hexamethylene azelamide), poly(hexamethylene succinamide), poly(hexamethylene lauramide), poly(hexamethylene sebacamide), poly(decamethylene sebacamide), polyundecanamide, poly(lauramide), poly(octanamide), poly(9-amino nonanoic acid), polycaprolactam, poly(phenylene terephthalamide), poly(hexylene isophthalamide), polyhexamethylene terephthalamide and poly(nonylene terephthalamide)) poly(aromatic ether), polyether imide, polycarbonate/(acrylonitrile-butadiene-styrene) alloy, polyphenylene oxide, polyphenylene sulfide, polyimide, polysulfone, poly(ether-ether-ketone), polybenzimidazole, phenol formaldehyde resin, urea formaldehyde resin, melamine-formaldehyde resin, epoxide resin, alkyd resin, and polyurethane.

In some embodiments, the plastic composition, depending on actual needs, may further contain at least one additive, such as filler, antioxidant, light stabilizer and lubricant to improve the performance or add new performance of the plastic article. There is no special limitation to the content and the type of the additive. The additive may be selected according to, for example, practical requirements.

In some embodiments, the filler may be any filler which is non-reactive under the effect of laser (either physically or chemically), such as, talc and calcium carbonate. Notwithstanding glass fiber is insensitivity to laser, however, by adding glass fiber, the thickness of the removed substrate (in other words, the distance from the top surface of the polymer product to the exposed doped tin oxide) may be significantly increased. This may facilitate the adhesion of copper onto the doped tin oxide during the following chemical copper plating process. The filler may be any conventional inorganic filler which may act with the effect of the energy source, such as the laser. In some embodiments, the filler may also be selected from a group consisting of micro glass bead, calcium sulfate, barium sulfate, titanium dioxide, pearl powder, wollastonite, diatomite, caoline, coal fines, pot clay, mica, oil shale ash, aluminum silicate, alumina, silica, talc and zinc oxide.

In some embodiments, the antioxidant may improve an antioxygenic property of the plastic article obtained, thus to increase its life of use. The antioxidant may be any conventional antioxidant in the related art. In some embodiments, the antioxidant may contain a primary antioxidant and a secondary antioxidant. The ratio between the primary antioxidant and the secondary antioxidant may be appropriately selected according to, for example, the type of the antioxidants. In some embodiments, the weight ratio between the primary antioxidant and the secondary antioxidant may be 1:1-4. The primary antioxidant may be a hindered phenol antioxidant. By way of example but without limits, in some embodiments, the primary antioxidant may be antioxidant 1098 or antioxidant 1010, in which the antioxidant 1098 mainly contains N,N' -bis-(3-(3,5-di-tert-butyl-4-hydroxyphenyl)propionyl)hexane diamine and the antioxidant 1010 mainly contains tetra[3-(3,5-di-tert-butyl-4-hydroxyphenyl)propionic acid]pentaerythritol. The secondary antioxidant may be a phosphite ester antioxidant. By way of example and without limits, in some embodiments, the secondary antioxidant may be antioxidant 168, which mainly contains tri(2,4-di-tert-butyl-phenyl)phosphorite.

In some embodiments, the light stabilizer may be any commonly used light stabilizer, for example, a hindered amine type. In some embodiments, the light stabilizer may be bis(2,2,6,6-tetramethyl-4-piperidyl)sebacate.

In some embodiments, the lubricant may be at least one selected from a group consisting of ethylene/vinyl acetate copolymer (EVA wax), polyethylene (PE wax) and stearate. With the addition of the lubricant, the flowing performance of the polymer melt may be improved.

In some embodiments, the amount of the additive may be appropriately selected according to functions and types of the additives. In some embodiments, based on 100 weight parts of the polymer composition, the content of the filler may range from 1 weight part to 40 weight parts, the content of the antioxidant may range from 0.1 weight parts to 10 weight parts, the content of the light stabilizer may range from 0.1 weight parts to 10 weight parts, and the content of the lubricant may range from 0.1 weight parts to 10 weight parts.

In some embodiments, only a part of a surface of the plastic substrate may be formed by the plastic composition. Alternatively, the whole plastic substrate may be formed by the plastic composition as mentioned above, i.e., the entire plastic substrate is formed by the plastic composition. From the viewpoint of cost reduction, only a surface or a part of a surface of the plastic substrate may be formed by the plastic composition if the size thereof is very large. The plastic substrate may be integrally formed by the polymer composition if the size is not very large.

According to embodiments of the present disclosure, there is no special limitation to a size of the plastic substrate. The size of the plastic substrate may be selected properly according to intended use of the case. The plastic substrate can be any shape according to practical use.

In some embodiments, the plastic substrate may be prepared by any conventional process known in the art, such as extrusion molding and injection molding.

According to the present disclosure, the thickness of the metal layer may be selected according to practical requirements, without special limits. In some embodiments, the thickness of the metal layer is 0.1 µm to 10 µm.

In some embodiments, the metal layer may have various shapes depend on practical requirements. For example, if the plastic article is used to prepare a circuit board, the metal layer may form a circuit pattern.

Embodiments of a first aspect of the present disclosure provides a method for selectively metalizing a surface of a plastic substrate. The method includes: removing at least a part of the plastic substrate by irradiating a surface of the plastic substrate with an energy source; and forming at least one metal plating layer on the surface of the plastic substrate by chemical plating. At least a surface layer of the plastic substrate covered by the metal plating layer is formed by a plastic composition. The plastic composition includes a base resin and a doped tin oxide. A doping element of the doped tin oxide is at least one selected from a group consisting of cerium and lanthanum. In other words, at least a part of the plastic substrate is irradiated by an energy source to gasify the surface of the irradiated surface, and then the plastic substrate after being irradiated is chemical plated. The surface layer of the plastic substrate that needs to be metalized is formed by a plastic composition. The plastic composition includes a base resin and a doped tin oxide or a filler coated by the doped tin oxide. A doping element of the doped tin oxide is at least one selected from a group consisting of cerium and lanthanum.

According to the present disclosure, the doped tin oxide, the plastic composition, the plastic substrate, and the base resin have been described above in detail.

According to embodiments of the present disclosure, the energy source may be at least one selected from a group consisting of laser, electron beam, and ion beam. In an embodiment, the energy source is a laser. The energy provided should be high enough to cause the plastic substrate in the irradiated area of the surface thereof to be gasified and the doped tin oxide in the irradiated area to be exposed. In some embodiments, the irradiating step may be performed using a laser, which may have a wavelength of 157-10600 nm and a power of 1-100 W. In some embodiments, the irradiating step may be performed using an electron beam, which may have a power density of 10-10¹¹ W/cm². In some embodiments, the irradiating step may be performed using an ion beam, which may have an energy of 10-10⁶ eV. In order to improve accuracy of the pattern formed by chemical plating, the irradiating step is performed using a laser. The doped tin oxide has excellent absorption capability to energy provided by the energy source, and thus the plastic substrate in the predetermined part may be removed and the doped tin oxide in the predetermined part may be exposed, even when irradiated with the energy source which provides relatively lower energy. In an embodiment, the energy source may have a wavelength of 1064-10600 nm and a power of 3-50 W. In another embodiment, the energy source may have a wavelength of 1064 nm and a power of 3-40 W. In a further embodiment, the energy source may have a wavelength of 1064 nm and a power of 5-20 W.

It should be noted that the chemical plating process is well known by those skilled in the art. For example, in some embodiments, a copper plating process may be carried out with the following steps. The plastic substrate subjected to the irradiating is immersed in a copper plating solution. In some embodiments, the copper plating solution may contain a Cu salt and a reducing agent. The copper plating solution may have a pH ranging from 12 to 13. The reducing agent may reduce the Cu ions in the Cu salt into Cu metal. In some embodiments, the reducing agent may be at least one selected from a group consisting of glyoxylic acid, diamide, and sodium hypophosphite.

The thickness of the metal layer formed by chemical plating may be selected based on practical requirements, without special limit. In some embodiments, the thickness of the metal layer is 0.1 µm to 10 µm.

In some embodiments, the shape of the metal layer may be selected based on practical requirements. For example, if the plastic article obtained after the chemical plating is used to prepare a circuit board, the metal layer may form a circuit pattern.

In some embodiments, the method may further include a step of electroplating or chemical plating. The electroplating or chemical plating may be performed for at least one time, so as to increase the thickness of the metal layer or add additional metal layer on the prior metal layers. In some embodiments, a Cu layer is formed on the surface of the plastic substrate in the first chemical plating step, and then a Ni layer is formed on the Cu layer in the following electroplating or chemical plating. With the additional Ni layer, oxidation of the Cu layer may be prevented.

The metal layer formed on the plastic article obtained by the method of the present disclosure is a complete continuous metal layer with a high adhesion to the plastic substrate.

Some illustrative and non-limiting embodiments are provided herein for a better understanding of the present invention and for its practical embodiment.

In these embodiments below, a constitution of the metal compound is measured by inductively coupled plasma atomic emission spectrometry(ICP).

In these Embodiments and Comparative Embodiments below, a volume average particle size of the doped tin oxide was measured by a Laser Particle Analyzer commercially available from Chengdu Jingxin Powder Analyse Instrument Co., Ltd., China.

In these Embodiments and Comparative Embodiments below, a light absorption rate of the doped tin oxide was measured by a lambda 750 UV/VIS/NIR spectrophotometer measured at a wavelength of 1064 nm.

In these Embodiments and Comparative Embodiments below, an adhesive force between the metal layer and the plastic substrate was measured by a cross-cut process. Specifically, a surface of the sample to be measured was cut using a cross-cut knife to form 10 × 10 grids (each grid has a size of 1 mm X 1 mm). A gap between adjacent grids was formed to reach the bottommost of the metal layer. Debris in the test region was cleaned using a brush, and then an adhesive tape (3M600 gummed paper) was stuck to a tested grid. One end of the stuck adhesive paper was rapidly torn off in a vertical direction. Two identical tests were performed on the same grid region. The grade of the adhesion was determined according to the following standard:
Grade 0: the cut edge is smooth and the metal layers both at the cut edge and cut intersection of the grid do not fall off;
Grade 1: the metal layers at the cut intersection are partly removed, but no more than 5% (area percent) of the metal layers are removed;
Grade 2: the metal layers both at the cut edge and the cut intersection are partly removed, and 5-15% (area percent) of the metal layers are removed;
Grade 3: the metal layers at both the cut edge and the cut intersection are partly removed, and 15-35% (area percent) of the metal layers are removed;
Grade 4: the metal layers at both the cut edge and the cut intersection are partly removed, and 35-65% (area percent) of the metal layers are removed;
Grade 5: the metal layers at both the cut edge and the cut intersection are partly removed, and more than 65% (area percent) of the metal layers are removed.

### Embodiment 1

(1) 46.5 mmol citric acid tin, 0.47 mmol LaN₃O₉ • 6H₂O, 248 mmol citric acid and 511 mmol ethylene glycol are mixed, and a 10 wt% nitric acid is added to dissolve these raw materials to obtain a mixture. The mixture is heated to 180 Celsius degrees to esterify the mixture for 60 minutes, and then the obtained mixture is sintered for about 15 hours under a temperature of about 900 Celsius degrees to obtain a sintered product. Then the sintered product is grinded to obtain a product having a volume average diameter of 1.5 microns so as to obtain a doped tin oxide. After measurement, the doped tin oxide includes 0.99SnO₂ · 0.01La₂O₃ and a light absorption rate of the doped tin oxide under a wave length of 1064 nanometers is recorded in Table 1.
(2) The obtained doped tin oxide of step (1) is added into a polycarbonate and mixed evenly to obtain a mixture. The mixture is fed into an extruder, and extruded and granulated. The obtained granules are fed into an injection molding machine to be injection molded, thus to obtain a plastic sheet containing doping tin oxide. Based on 100 weight parts of the polycarbonate, the doped tin oxide has a content of 3 weight parts.
(3) A surface of the obtained plastic sheet of step (2) is irradiated by a laser generated by a YAG laser device so as to form a pattern of antenna as a receiver. The irradiating conditions include: a wave length of 1064 nanometers, a power of 8 W, a frequency of 20 kHz, a speed of 2000 millimeters per second, and a filling distance of 30 microns.
(4) The plastic sheet obtained from step (3) is placed in a plating solution and chemical plated so as to form an antenna pattern of metal plating layer to obtain a plastic article. The plating solution includes: 0.12 mol/L CuSO₄ · 5H₂O, 0.14mol/L Na₂EDTA · 2H₂O, 10mg/L potassium ferrocyanide, 10mg/L 2,2'- pyridine, and 0.10mol/L glyoxylic acid., The plating solution has a pH value of about 12.5-13, regulated by NaOH and H₂SO₄, and the plating solution has a temperature of 50 Celsius degrees.

By visual observation, the formed antenna is of integrity. The plating speed and adhesive force of the metal plating layer are shown in Table 1.

### Embodiment 2

(1) The step (1) of Embodiment 2 is substantially the same as the step (1) of Embodiment 1, with the exception that: the LaN₃O₉ · 6H₂O has a dosage of 2.45 mmol, the citric acid has a dosage of 1 mol, and the ethylene glycol has a dosage of 2.5 mol, and the sintered product is grinded to obtain a product having a volume average diameter of 1 microns so as to obtain a doped tin oxide. After measurement, the doped tin oxide includes 0.95SnO₂ · 0.05La₂O₃ and a light absorption rate of the doped tin oxide under a wave length of 1064 nanometers is recorded in Table 1.
(2) The step (2) of Embodiment 2 is substantially the same as the step (2) of Embodiment 1, with the exception that: the doped tin oxide used here is the doped tin oxide obtained from step (1) of Embodiment 2, and based on 100 weight parts of the polycarbonate, the doped tin oxide has a content of 5 weight parts.
(3) The step (3) of Embodiment 2 is substantially the same as the step (3) of Embodiment 1.
(4) The step (4) of Embodiment 2 is substantially the same as the step (4) of Embodiment 1.

By visual observation, the formed antenna is of integrity. The plating speed and adhesive force of the metal plating layer are shown in Table 1.

### Embodiment 3

(1) The step (1) of Embodiment 3 is substantially the same as the step (1) of Embodiment 1, with the exception that: the LaN₃O₉ · 6H₂O has a dosage of 4.04 mmol, the citric acid has a dosage of 1.2 mol, and the ethylene glycol has a dosage of 2.8 mol, and the sintered product is grinded to obtain a product having a volume average diameter of 3 microns so as to obtain a doped tin oxide. After measurement, the doped tin oxide includes 0.92SnO₂ · 0.08La₂O₃ and a light absorption rate of the doped tin oxide under a wave length of 1064 nanometers is recorded in Table 1.
(2) The step (2) of Embodiment 3 is substantially the same as the step (2) of Embodiment 1, with the exception that: the doped tin oxide used here is the doped tin oxide obtained from step (1) of Embodiment 3, and based on 100 weight parts of the polycarbonate, the doped tin oxide has a content of 10 weight parts.
(3) The step (3) of Embodiment 3 is substantially the same as the step (3) of Embodiment 1.
(4) The step (4) of Embodiment 3 is substantially the same as the step (4) of Embodiment 1.

By visual observation, the formed antenna is of integrity. The plating speed and adhesive force of the metal plating layer are shown in Table 1.

### Embodiment 4

(1) 46.5 mmol citric acid tin, 0.47 mmol CeN₃O₉ · 6H₂O, 248 mmol citric acid and 511 mmol ethylene glycol are mixed, and a 10 wt% nitric acid is added to dissolve these raw materials to obtain a mixture. The mixture is heated to 180 Celsius degrees to esterify the mixture for 60 minutes, and then the obtained mixture is sintered for about 15 hours under a temperature of about 900 Celsius degrees to obtain a sintered product. Then the sintered product is grinded to obtain a product having a volume average diameter of 1.5 microns so as to obtain a doped tin oxide. After measurement, the doped tin oxide includes 0.99SnO₂ · 0.01Ce₂O₃ and a light absorption rate of the doped tin oxide under a wave length of 1064 nanometers is recorded in Table 1.
(2) The obtained doped tin oxide of step (1) is added into a polycarbonate and mixed evenly to obtain a mixture. The mixture is fed into an extruder, and extruded and granulated. The obtained granules are fed into an injection molding machine to be injection molded, thus to obtain a plastic sheet containing doping tin oxide. Based on 100 weight parts of the polycarbonate, the doped tin oxide has a content of 3 weight parts.
(3) A surface of the obtained plastic sheet of step (2) is irradiated by a laser generated by a YAG laser device so as to form a pattern of antenna as a receiver. The irradiating conditions include: a wave length of 1064 nanometers, a power of 8 W, a frequency of 20 kHz, a speed of 2000 millimeters per second, and a filling distance of 30 microns.
(4) The plastic sheet obtained from step (3) is placed in a plating solution and chemical plated so as to form an antenna pattern of metal plating layer to obtain a plastic article. The plating solution includes: 0.12 mol/L CuSO₄ · 5H₂O, 0.14mol/L Na₂EDTA · 2H₂O, 10mg/L potassium ferrocyanide, 10mg/L 2,2'- pyridine, and 0.10mol/L glyoxylic acid. The plating solution has a pH value of about 12.5-13, regulated by NaOH and H₂SO₄, and the plating solution has a temperature of 50 Celsius degrees.

By visual observation, the formed antenna is of integrity. The plating speed and adhesive force of the metal plating layer are shown in Table 1.

### Embodiment 5

(1) The step (1) of Embodiment 5 is substantially the same as the step (1) of Embodiment 4, with the exception that: the CeN₃O₉ · 6H₂O has a dosage of 2.45 mmol, the citric acid has a dosage of 1 mol, and the ethylene glycol has a dosage of 2.5 mol, and the sintered product is grinded to obtain a product having a volume average diameter of 1 microns so as to obtain a doped tin oxide. After measurement, the doped tin oxide includes 0.95SnO₂ · 0.05Ce₂O₃ and a light absorption rate of the doped tin oxide under a wave length of 1064 nanometers is recorded in Table 1.
(2) The step (2) of Embodiment 5 is substantially the same as the step (2) of Embodiment 4, with the exception that: the doped tin oxide used here is the doped tin oxide obtained from step (1) of Embodiment 5, and based on 100 weight parts of the polycarbonate, the doped tin oxide has a content of 5 weight parts.
(3) The step (3) of Embodiment 5 is substantially the same as the step (3) of Embodiment 4.
(4) The step (4) of Embodiment 5 is substantially the same as the step (4) of Embodiment 4.

By visual observation, the formed antenna is of integrity. The plating speed and adhesive force of the metal plating layer are shown in Table 1.

### Embodiment 6

(1) The step (1) of Embodiment 6 is substantially the same as the step (1) of Embodiment 4, with the exception that: the CeN₃O₉ · 6H₂O has a dosage of 4.04 mmol, the citric acid has a dosage of 1.2 mol, and the ethylene glycol has a dosage of 2.8 mol, and the sintered product is grinded to obtain a product having a volume average diameter of 3 microns so as to obtain a doped tin oxide. After measurement, the doped tin oxide includes 0.92SnO₂ · 0.08Ce₂O₃ and a light absorption rate of the doped tin oxide under a wave length of 1064 nanometers is recorded in Table 1.
(2) The step (2) of Embodiment 6 is substantially the same as the step (2) of Embodiment 4, with the exception that: the doped tin oxide used here is the doped tin oxide obtained from step (1) of Embodiment 6, and based on 100 weight parts of the polycarbonate, the doped tin oxide has a content of 10 weight parts.
(3) The step (3) of Embodiment 6 is substantially the same as the step (3) of Embodiment 4.
(4) The step (4) of Embodiment 6 is substantially the same as the step (4) of Embodiment 4.

By visual observation, the formed antenna is of integrity. The plating speed and adhesive force of the metal plating layer are shown in Table 1.

### Embodiment 7 (not part of the invention)

(1) 465 mmol SnO₂ is placed in a ball grinding pot of a ball grinder and ball grinded for 2 hours by adding 2.35 mmol Ta₂O₅ and ethyl alcohol. Based on 100 weight part of solid material, the ethyl alcohol has a content of 300 weight parts. The mixture obtained after ball grinding is dried in air atmosphere under 80 Celsius degrees for 3 hours to obtain a powder mixture having a volume average diameter of 2.6 microns. The powder mixture is roasted in air atmosphere under 1000 Celsius degrees for 12 hours and then the product obtained after roasting is grinded so as to obtain a doped tin oxide having a volume average diameter of 1.6 microns. After measurement, the doped tin oxide includes 0.99SnO₂ · 0.08Ta₂O₅ and a light absorption rate of the doped tin oxide under a wave length of 1064 nanometers is recorded in Table 1.
(2) The obtained doped tin oxide of step (1) is added into a polycarbonate and mixed evenly to obtain a mixture. The mixture is fed into an extruder, and extruded and granulated. The obtained granules are fed into an injection molding machine to be injection molded, thus to obtain a plastic sheet containing doping tin oxide. Based on 100 weight parts of the polycarbonate, the doped tin oxide has a content of 3 weight parts.
(3) A surface of the obtained plastic sheet of step (2) is irradiated by a laser generated by a YAG laser device so as to form a pattern of antenna as a receiver. The irradiating conditions include: a wave length of 1064 nanometers, a power of 8 W, a frequency of 20 kHz, a speed of 2000 millimeters per second, and a filling distance of 30 microns.
(4) The plastic sheet obtained from step (3) is placed in a plating solution and chemical plated so as to form an antenna pattern of metal plating layer to obtain a plastic article. The plating solution includes: 0.12 mol/L CuSO₄ · 5H₂O, 0.14mol/L Na₂EDTA · 2H₂O, 10mg/L potassium ferrocyanide, 10mg/L 2,2'- pyridine, and 0.10mol/L glyoxylic acid. The plating solution has a pH value of about 12.5-13, regulated by NaOH and H₂SO₄, and the plating solution has a temperature of 50 Celsius degrees.

By visual observation, the formed antenna is of integrity. The plating speed and adhesive force of the metal plating layer are shown in Table 1.

### Embodiment 8 (not part of the invention)

(1) The step (1) of Embodiment 8 is substantially the same as the step (1) of Embodiment 7, with the exception that: the Ta₂O₅ has a dosage of 1.225 mmol. After measurement, the doped tin oxide includes 0.95SnO₂ · 0.025Ta₂O₃ and a light absorption rate of the doped tin oxide under a wave length of 1064 nanometers is recorded in Table 1.
(2) The step (2) of Embodiment 8 is substantially the same as the step (2) of Embodiment 7, with the exception that: the doped tin oxide used here is the doped tin oxide obtained from step (1) of Embodiment 8, and based on 100 weight parts of the polycarbonate, the doped tin oxide has a content of 5 weight parts.
(3) The step (3) of Embodiment 8 is substantially the same as the step (3) of Embodiment 7.
(4) The step (4) of Embodiment 8 is substantially the same as the step (4) of Embodiment 7.

By visual observation, the formed antenna is of integrity. The plating speed and adhesive force of the metal plating layer are shown in Table 1.

### Embodiment 9 (not part of the invention)

(1) The step (1) of Embodiment 9 is substantially the same as the step (1) of Embodiment 7, with the exception that: the Ta₂O₅ has a dosage of 2.02 mmol. After measurement, the doped tin oxide includes 0.92SnO₂ · 0.04Ta₂O₃ and a light absorption rate of the doped tin oxide under a wave length of 1064 nanometers is recorded in Table 1.
(2) The step (2) of Embodiment 9 is substantially the same as the step (2) of Embodiment 7, with the exception that: the doped tin oxide used here is the doped tin oxide obtained from step (1) of Embodiment 9, and based on 100 weight parts of the polycarbonate, the doped tin oxide has a content of 10 weight parts.
(3) The step (3) of Embodiment 9 is substantially the same as the step (3) of Embodiment 7.
(4) The step (4) of Embodiment 9 is substantially the same as the step (4) of Embodiment 7.

By visual observation, the formed antenna is of integrity. The plating speed and adhesive force of the metal plating layer are shown in Table 1.

### Embodiment 10 (not part of the invention)

(1) 46.5 mmol citric acid tin, 248 mmol citric acid and 511 mmol ethylene glycol are mixed, and a 10 wt% nitric acid is added to dissolve these raw materials to obtain a mixture. The mixture is heated to 180 Celsius degrees to esterify the mixture for 60 minutes, and then a 0.47 mmol hydrofluoric acid is added into the obtained esterified product to form a mixture. Then the mixture is sintered for about 15 hours under a temperature of about 900 Celsius degrees to obtain a sintered product. Then the sintered product is grinded to obtain a product having a volume average diameter of 1.5 microns so as to obtain a doped tin oxide. After measurement, the doped tin oxide includes SnO_{1.99}F_{0.01} and a light absorption rate of the doped tin oxide under a wave length of 1064 nanometers is recorded in Table 1.
(2) The obtained doped tin oxide of step (1) is added into a polycarbonate and mixed evenly to obtain a mixture. The mixture is fed into an extruder, and extruded and granulated. The obtained granules are fed into an injection molding machine to be injection molded, thus to obtain a plastic sheet containing doping tin oxide. Based on 100 weight parts of the polycarbonate, the doped tin oxide has a content of 3 weight parts.
(3) A surface of the obtained plastic sheet of step (2) is irradiated by a laser generated by a YAG laser device so as to form a pattern of antenna as a receiver. The irradiating conditions include: a wave length of 1064 nanometers, a power of 8 W, a frequency of 20 kHz, a speed of 2000 millimeters per second, and a filling distance of 30 microns.
(4) The plastic sheet obtained from step (3) is placed in a plating solution and chemical plated so as to form an antenna pattern of metal plating layer to obtain a plastic article. The plating solution includes: 0.12 mol/L CuSO₄ · 5H₂O, 0.14mol/L Na₂EDTA · 2H₂O, 10mg/L potassium ferrocyanide, 10mg/L 2,2'- pyridine, and 0.10mol/L glyoxylic acid. The plating solution has a pH value of about 12.5-13 regulated by NaOH and H₂SO₄, and the plating solution has a temperature of 50 Celsius degrees.

By visual observation, the formed antenna is of integrity. The plating speed and adhesive force of the metal plating layer are shown in Table 1.

### Embodiment 11 (not part of the invention)

(1) The step (1) of Embodiment 11 is substantially the same as the step (1) of Embodiment 10, with the exception that: the hydrofluoric acid has a dosage of 2.45 mmol, the citric acid has a dosage of 1 mol, and the ethylene glycol has a dosage of 2.5 mol, and the sintered product is grinded to obtain a product having a volume average diameter of 1 microns so as to obtain a doped tin oxide. After measurement, the doped tin oxide includes SnO_{1.947}F₀.₀₅₃ and a light absorption rate of the doped tin oxide under a wave length of 1064 nanometers is recorded in Table 1.
(2) The step (2) of Embodiment 11 is substantially the same as the step (2) of Embodiment 10, with the exception that: the doped tin oxide used here is the doped tin oxide obtained from step (1) of Embodiment 11, and based on 100 weight parts of the polycarbonate, the doped tin oxide has a content of 5 weight parts.
(3) The step (3) of Embodiment 11 is substantially the same as the step (3) of Embodiment 10.
(4) The step (4) of Embodiment 11 is substantially the same as the step (4) of Embodiment 10.

By visual observation, the formed antenna is of integrity. The plating speed and adhesive force of the metal plating layer are shown in Table 1.

### Embodiment 12 (not part of the invention)

(1) The step (1) of Embodiment 12 is substantially the same as the step (1) of Embodiment 10, with the exception that: the hydrofluoric acid has a dosage of 4.04 mmol, the citric acid has a dosage of 1.2 mol, and the ethylene glycol has a dosage of 2.8 mol, and the sintered product is grinded to obtain a product having a volume average diameter of 1 microns so as to obtain a doped tin oxide. After measurement, the doped tin oxide includes SnO₁.₉₁₃F₀.₀₈₇ and a light absorption rate of the doped tin oxide under a wave length of 1064 nanometers is recorded in Table 1.
(2) The step (2) of Embodiment 12 is substantially the same as the step (2) of Embodiment 10, with the exception that: the doped tin oxide used here is the doped tin oxide obtained from step (1) of Embodiment 12, and based on 100 weight parts of the polycarbonate, the doped tin oxide has a content of 10 weight parts.
(3) The step (3) of Embodiment 12 is substantially the same as the step (3) of Embodiment 10.
(4) The step (4) of Embodiment 12 is substantially the same as the step (4) of Embodiment 10.

By visual observation, the formed antenna is of integrity. The plating speed and adhesive force of the metal plating layer are shown in Table 1.

### Embodiment 13

(1) The step (1) of Embodiment 13 is substantially the same as the step (1) of Embodiment 1, with the exception that: 46.5 mmol citric acid tin, 0.47 mmol LaN₃O₉ · 6H₂O, 248 mmol citric acid, 511 mmol ethylene glycol and 1 mmol mica are mixed so as to obtained a filler coated by doped tin oxide. After measurement, the doped tin oxide includes 0.99SnO₂ · 0.01La₂O₃, and a light absorption rate of the doped tin oxide under a wave length of 1064 nanometers is recorded in Table 1.
(2) The step (2) of Embodiment 13 is substantially the same as the step (2) of Embodiment 1, with the exception that: the doped tin oxide used here is the doped tin oxide obtained from step (1) of Embodiment 13, and based on 100 weight parts of the polycarbonate, the doped tin oxide has a content of 5 weight parts.
(3) The step (3) of Embodiment 13 is substantially the same as the step (3) of Embodiment 1.
(4) The step (4) of Embodiment 13 is substantially the same as the step (4) of Embodiment 1.

By visual observation, the formed antenna is of integrity. The plating speed and adhesive force of the metal plating layer are shown in Table 1.

### Comparative Embodiment 1

(1) The step (1) of Comparative Embodiment 1 is substantially the same as the step (1) of Embodiment 1, with the exception that: LaN₃O₉ · 6H₂O is substituted by Sbc₁₃. After measurement, the doped tin oxide includes 0.99SnO₂ · 0.01SbO₂, and a light absorption rate of the doped tin oxide under a wave length of 1064 nanometers is recorded in Table 1.
(2) The step (2) of Comparative Embodiment 1 is substantially the same as the step (2) of Embodiment 1, with the exception that: the doped tin oxide used here is the doped tin oxide obtained from step (1) of Comparative Embodiment 1.
(3) The step (3) of Comparative Embodiment 1 is substantially the same as the step (3) of Embodiment 1.
(4) The step (4) of Comparative Embodiment 1 is substantially the same as the step (4) of Embodiment 1.

By visual observation, a metal layer could be obtained, but over-plating phenomenon and copper powder-hanging phenomenon occur. The plating speed and adhesive force of the metal plating layer are shown in Table 1.

**Table 1**

| | Plating speed(µ m/h) | Adhesive force | Light absorption rate of the doped tin oxide(%) |
|---|---|---|---|
| Embodiment 1 | 7 | 0 | 70 |
| Embodiment 2 | 8 | 1 | 75 |
| Embodiment 3 | 10 | 0 | 77 |
| Embodiment 4 | 7 | 0 | 66 |
| Embodiment 5 | 9 | 1 | 70 |
| Embodiment 6 | 11 | 0 | 78 |
| Embodiment 7 | 6 | 1 | 60 |
| Embodiment 8 | 7 | 0 | 66 |
| Embodiment 9 | 8 | 0 | 75 |
| Embodiment 10 | 8 | 0 | 71 |
| Embodiment 11 | 9 | 1 | 80 |
| Embodiment 12 | 11 | 1 | 85 |
| Embodiment 13 | 11 | 1 | 84 |
| Comparative Embodiment 1 | 5 | 2 | 60 |

## Claims

1. A metallized plastic article comprising:
a plastic substrate; and
a metal plating layer formed on surface of the plastic substrate;
wherein a surface layer of the plastic substrate covered by the metal plating layer is formed by a plastic composition, the plastic composition comprises:
a base resin; and
a doped tin oxide dispersed in the base resin; and
wherein a doping element of the doped tin oxide is at least one selected from a group consisting of cerium and lanthanum.

2. The metallized plastic article of claim 1, wherein the metal plating layer has a thickness of 0.1 µm to 10µm.

3. The metallized plastic article of claim 1, wherein based on total molar quantity of tin element and the doping element of the doped tin oxide, the tin element has a content of 90mol% to 99.9mol%, the doping element has a content of 0.1mol% to 10mol%.

4. The metallized plastic article of any one of claims 1-3, wherein the doped tin oxide is present in the form of particles having a volume average particle size, measured by a laser particle analyzer, of 50 nm to 10 µm.

5. The metallized plastic article of any one of claims 1-3, wherein the plastic composition further comprises:
a filler coated by the doped tin oxide.

6. The metallized plastic article of claim 5, wherein the filler has a volume average particle size of 50 nm to 10 µm, measured by a laser particle analyzer.

7. The metallized plastic article of claim 5 or 6, wherein the filler is at least one selected from a group consisting of mica and silicon dioxide.

8. The metallized plastic article of any one of claims 1-4, wherein based on 100 weight parts of the base resin, the doped tin oxide has a content of 1 weight part to 20 weight parts.

9. The metallized plastic article of any one of claims 5-7, wherein the filler has a content of 1 weight part to 20 weight parts, based on 100 weight parts of the base resin.

10. The metallized plastic article of any one of claims 1-9, wherein the base resin is at least one selected from a group consisting of: polyolefin, polycarbonate, polyester, polyamide, poly(aromatic ether), polyphenylene oxide, polyphenylene sulfide, polyimide, polysulfone, poly(ether-ether-ketone), polybenzimidazole, phenol formaldehyde resin, urea formaldehyde resin, melamine-formaldehyde resin, epoxide resin, alkyd resin, and polyurethane.

11. A method for preparing a selectively metallized plastic article as defined in any one of the claims 1 to 10, the method comprising:
removing at least a part of a plastic substrate by irradiating the surface of the plastic substrate with an energy source; and
forming at least one metal plating layer on the surface of the plastic substrate by chemical plating; wherein at least a surface layer of the plastic substrate covered by the metal plating layer is formed by a plastic composition, the plastic composition comprises:
a base resin; and
a doped tin oxide dispersed in the base resin; and
wherein a doping element of the doped tin oxide is at least one selected from a group consisting of cerium and lanthanum.

12. The method of claim 11, wherein the energy source includes a laser.

13. The method of claim 12, wherein the laser has a wavelength of 1064 nm and a power of 3-40 W.

## Patentansprüche

1. Metallisierter Kunststoffgegenstand, enthaltend:
ein Kunststoffsubstrat und
eine Metallplattierschicht, die auf einer Oberfläche des Kunststoffsubstrates gebildet ist,
worin eine Oberflächenschicht des Kunststoffsubstrates, die durch die Metallplattierschicht bedeckt ist, durch eine Kunststoffzusammensetzung gebildet ist, wobei die Kunststoffzusammensetzung enthält:
ein Grundharz und
ein dotiertes Zinnoxid, das im Grundharz dispergiert ist, und
worin ein Dotierelement des dotierten Zinnoxides zumindest eines ist, ausgewählt aus der Gruppe, bestehend aus Cer und Lanthan.

2. Metallisierter Kunststoffgegenstand gemäß Anspruch 1, worin die Metallplattierschicht eine Dicke von 0,1 bis 10 µm hat.

3. Metallisierter Kunststoffgegenstand gemäß Anspruch 1, worin auf der Basis der gesamten molaren Menge des Zinnelementes und des Dotierelementes des dotierten Zinnoxides das Zinnelement einen Gehalt von 90 bis 99,9 mol-% hat, das Dotierelement einen Gehalt von 0,1 bis 10 mol-% hat.

4. Metallisierter Kunststoffgegenstand gemäß einem der Ansprüche 1 bis 3, worin das dotierte Zinnoxid in der Form von Teilchen mit einer volumengemittelten Teilchengröße, gemessen durch ein Laser-Teilchenanalysegerät, von 50 nm bis 10 µm hat.

5. Metallisierter Kunststoffgegenstand gemäß einem der Ansprüche 1 bis 3, worin die Kunststoffzusammensetzung weiterhin einen Füllstoff enthält, der durch das dotierte Zinnoxid beschichtet ist.

6. Metallisierter Kunststoffgegenstand gemäß Anspruch 5, worin der Füllstoff eine volumengemittelte Teilchengröße von 50 nm bis 10 µm hat, gemessen durch ein Laser-Teilchenanalysegerät.

7. Metallisierter Kunststoffgegenstand gemäß Anspruch 5 oder 6, worin der Füllstoff zumindest einer ist, ausgewählt aus einer Gruppe, bestehend aus Mika und Siliciumdioxid.

8. Metallisierter Kunststoffgegenstand gemäß einem der Ansprüche 1 bis 4, worin auf der Basis von 100 Gewichtsteilen des Grundharzes das dotierte Zinnoxid einen Gehalt von 1 bis 20 Gewichtsteilen hat.

9. Metallisierter Kunststoffgegenstand gemäß einem der Ansprüche 5 bis 7, worin der Füllstoff einen Gehalt von 1 bis 20 Gewichtsteilen hat, bezogen auf 100 Gewichtsteile des Grundharzes.

10. Metallisierter Kunststoffgegenstand gemäß einem der Ansprüche 1 bis 9, worin das Grundharz zumindest eines ist, ausgewählt aus der Gruppe, bestehend aus Polyolefin, Polycarbonat, Polyester, Polyamid, Poly(aromatischem Ether), Polyphenylenoxid, Polyphenylensulfid, Polyimid, Polysulfon, Poly(etheretherketon), Polybenzimidazol, Phenol-Formaldehyd-Harz, Harnstoff-Formaldehyd-Harz, MelaminFormaldehyd-Harz, Epoxidharz, Alkydharz und Polyurethan.

11. Verfahren zur Herstellung eines selektiv metallisierten Kunststoffgegenstandes gemäß einem der Ansprüche 1 bis 10, wobei das Verfahren enthält:
Entfernen von zumindest einem Teil eines Kunststoffsubstrates durch Bestrahlen der Oberfläche des Kunststoffsubstrates mit einer Energiequelle und
Bilden von zumindest einer Metallplattierschicht auf der Oberfläche des Kunststoffsubstrates durch chemisches Plattieren, worin zumindest eine Oberflächenschicht des Kunststoffsubstrates, die durch die Metallplattierschicht bedeckt ist, durch eine Kunststoffzusammensetzung gebildet ist, wobei die Kunststoffzusammensetzung enthält:
ein Grundharz und
ein dotiertes Zinnoxid, dispergiert im Grundharz, und
worin ein Dotierelement des dotierten Zinnoxides zumindest eines ist, ausgewählt aus einer Gruppe, bestehend aus Cer und Lanthan.

12. Verfahren gemäß Anspruch 11, worin die Energiequelle einen Laser enthält.

13. Verfahren gemäß Anspruch 12, worin der Laser eine Wellenlänge von 1.064 nm und eine Leistung von 3 bis 40 W hat.

## Revendications

1. Article de matière plastique métallisé comprenant :
un substrat de matière plastique ; et
une couche de placage métallique formée sur une surface du substrat de matière plastique ;
dans lequel une couche de surface du substrat de matière plastique recouverte par la couche de placage métallique est formée par une composition de matière plastique, la composition de matière plastique comprenant :
une résine de base ; et
un oxyde d'étain dopé dispersé dans la résine de base ; et
dans lequel un élément de dopage de l'oxyde d'étain dopé est au moins un élément choisi dans un groupe consistant en du cérium et du lanthane.

2. Article de matière plastique métallisé selon la revendication 1, dans lequel la couche de placage métallique présente une épaisseur de 0,1 µm à 10 µm.

3. Article de matière plastique métallisé selon la revendication 1, dans lequel, sur la base de la quantité molaire totale de l'élément d'étain et de l'élément de dopage de l'oxyde d'étain dopé, l'élément d'étain présente une teneur de 90 % en mole à 99,9 % en mole, l'élément de dopage présentant une teneur de 0,1 % en mole à 10 % en mole.

4. Article de matière plastique métallisé selon l'une quelconque des revendications 1-3, dans lequel l'oxyde d'étain dopé est présent sous la forme de particules présentant une taille particulaire moyenne en volume, mesurée par un analyseur de particules à laser, de 50 nm à 10 µm.

5. Article de matière plastique métallisé selon l'une quelconque des revendications 1-3, dans lequel la composition de matière plastique comprend en outre :
une charge revêtue par l'oxyde d'étain dopé.

6. Article de matière plastique métallisé selon la revendication 5, dans lequel la charge présente une taille particulaire moyenne en volume de 50 nm à 10 µm, mesurée par un analyseur de particules à laser.

7. Article de matière plastique métallisé selon la revendication 5 ou 6, dans lequel la charge est au moins une charge choisie dans un groupe consistant en du mica et du dioxyde de silicium.

8. Article de matière plastique métallisé selon l'une quelconque des revendications 1-4, dans lequel, sur la base de 100 parties en poids de la résine de base, l'oxyde d'étain dopé à une teneur de 1 partie en poids à 20 parties en poids.

9. Article de matière plastique métallisé selon l'une quelconque des revendications 5-7, dans lequel la charge présente une teneur de 1 partie en poids à 20 parties en poids sur la base de 100 parties en poids de la résine de base.

10. Article de matière plastique métallisé selon l'une quelconque des revendications 1-9, dans lequel la résine de base est au moins une résine choisie dans le groupe consistant en une polyoléfine, un polycarbonate, un polyester, un polyamide, un poly(éther aromatique), un poly(oxyde de phénylène), un poly(sulfure de phénylène), un polyimide, une polysulfone, une poly(éther-éther-cétone), un polybenzimidazole, une résine de phénol formaldéhyde, une résine d'urée formaldéhyde, une résine de mélamine-formaldéhyde, une résine époxyde, une résine alkyde et un polyuréthane.

11. Procédé de préparation d'un article de matière plastique sélectivement métallisé selon l'une quelconque des revendications 1 à 10, le procédé comprenant :
le retrait d'au moins une partie du substrat de matière plastique en irradiant la surface du substrat de matière plastique par une source d'énergie ; et
la formation d'au moins une couche de placage métallique sur la surface du substrat de matière plastique par placage chimique ; dans lequel au moins une couche de surface du substrat de matière plastique revêtue par la couche de placage métallique est formée par une composition de matière plastique, la composition de matière plastique comprenant :
une résine de base ; et
un oxyde d'étain dopé dispersé dans la résine de base ; et
dans lequel un élément dopant de l'oxyde d'étain dopé est au moins un élément choisi dans un groupe consistant en du cérium et du lanthane.

12. Procédé selon la revendication 11, dans lequel la source d'énergie inclut un laser.

13. Procédé selon la revendication 12, dans lequel le laser présente une longueur d'onde de 1064 nm et une puissance de 3-40 W.
